(19) Europäisches Patentamt

European Patent Office

Office européen des brevets

(11) **EP 0 746 094 B1**

(12) **FASCICULE DE BREVET EUROPEEN**

(45) Date de publication et mention
de la délivrance du brevet:
**07.11.2001 Bulletin 2001/45**

(51) Int Cl.⁷: **H03F 1/30**, H03F 3/217

(21) Numéro de dépôt: **96410060.6**

(22) Date de dépôt: **28.05.1996**

(54) **Système de compensation de l'erreur de décalage d'un amplificateur opérationnel**

Verschiebungsfehlerkompensationseinrichtung für einen Operationsverstärker

Offset error compensation system for an operational amplifier

(84) Etats contractants désignés:
**DE FR GB IT**

(30) Priorité: **31.05.1995 FR 9506668**

(43) Date de publication de la demande:
**04.12.1996 Bulletin 1996/49**

(73) Titulaire: **STMicroelectronics S.A.**
**94250 Gentilly (FR)**

(72) Inventeur: **Nicolai, Jean**
**13790 Châteauneuf le Rouge (FR)**

(74) Mandataire: **de Beaumont, Michel**
**1bis, rue Champollion**
**38000 Grenoble (FR)**

(56) Documents cités:
**EP-A- 0 379 817**     **FR-A- 2 173 032**
**GB-A- 1 239 922**     **US-A- 3 237 116**

**Description**

La présente invention concerne un système de compensation de l'erreur de décalage d'un amplificateur opérationnel et plus particulièrement de l'erreur apparaissant dans un convertisseur analogique/numérique à bascule de Schmitt.

La présente invention vise plus particulièrement la réalisation d'un convertisseur analogique/numérique à faible coût présentant une précision élevée aussi bien dans une plage de tension à mesurer élevée que dans une plage de tension à mesurer très faible, par exemple pour mesurer avec des précisions du même ordre de grandeur des tensions de quelques volts et des tensions de quelques millivolts.

La présente invention s'applique notamment à des appareils portables dans lesquels on cherche à mesurer en permanence l'état de charge d'une batterie par sommation des puissances fournies par cette batterie. Dans certains appareils portables, le courant fourni par la batterie correspond à l'un ou l'autre de deux états de fonctionnement, un état de veille et un état de fonctionnement dans lesquels les courants sont très différents. Toutefois, si le courant de veille correspond à des durées beaucoup plus longues que le courant de fonctionnement, il est souhaitable de mesurer ce courant de veille avec la même précision que le courant de fonctionnement. C'est par exemple le cas d'un téléphone portable où le courant pendant les phases de fonctionnement peut être de l'ordre de 2 ampères tandis que le courant de veille peut être inférieur à 10 milliampères mais, bien entendu, dans une utilisation classique, les périodes de veille sont beaucoup plus longues que les périodes de fonctionnement.

A priori, pour réaliser ce type de calcul, on utilise un microcontrôleur associé à un convertisseur analogique/numérique. Si l'on veut une précision de l'ordre de 1/1000, il faut donc prévoir un convertisseur analogique/numérique d'une précision supérieure ou égale à 10 bits. Or, les microcontrôleurs classiques à faible coût, tels que le microcontrôleur ST6 sont couramment associés à des convertisseurs analogique/numérique d'une précision de seulement 8 bits (1/250).

L'objet de la présente invention est d'utiliser un tel microcontrôleur à faible coût tout en conservant une précision de l'ordre de un pour mille en ce qui concerne les mesures de tension.

Dans le cadre de cette approche, on connaît des circuits qui transforment des valeurs de tension en rapports cycliques de signal périodique. Il est alors possible, avec un microcontrôleur classique à faible coût qui dispose néanmoins d'une horloge et de compteurs à haute fréquence de calculer ces rapports cycliques à partir de comptages de temps de haute précision.

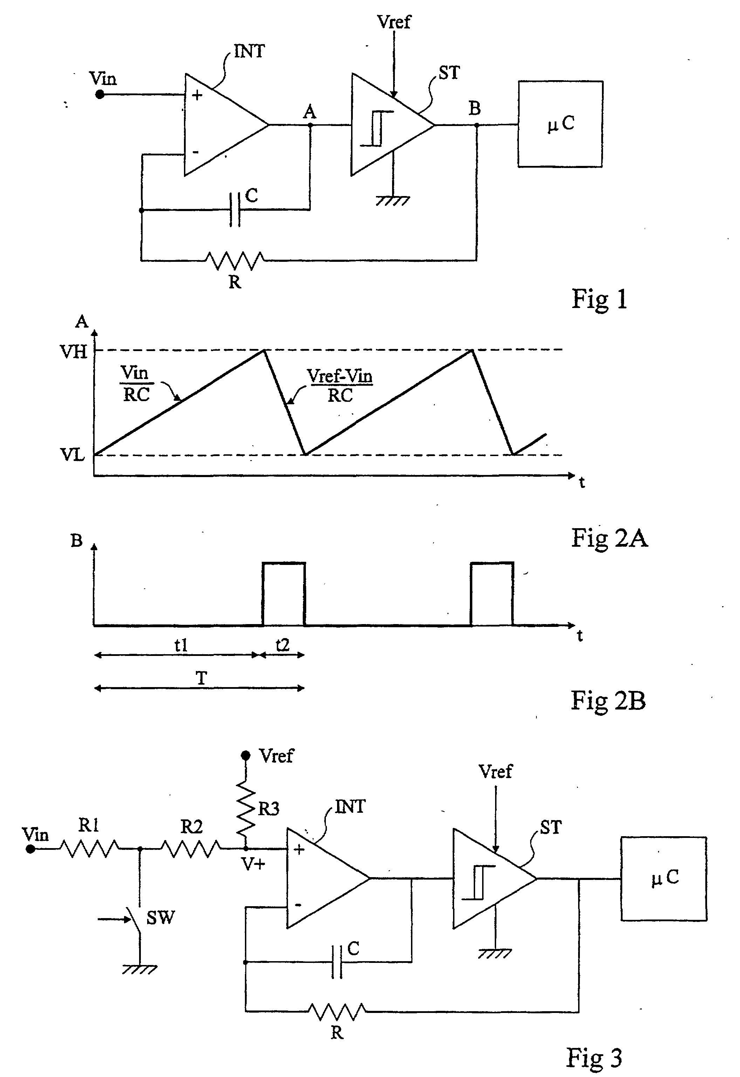

Un exemple de circuit transformant des valeurs de tension d'entrée à mesurer en rapports cycliques de signal périodique est illustré en figure 1 et correspond par exemple au circuit décrit dans l'article de Mike Walne, "Simple ADC is surprisingly accurate" paru dans EDN, European Edition, 9 juin 1994 P. 154.

Le circuit de la figure 1 comprend un amplificateur opérationnel INT dont la sortie est envoyée à une bascule (ou trigger) de Schmitt ST. La tension à mesurer Vin est apppliquée à l'entrée non-inverseuse de l'amplificateur opérationnel INT. L'entrée inverseuse de l'amplificateur opérationnel INT reçoit la sortie A de cet amplificateur opérationnel par l'intermédiaire d'un condensateur C et la sortie B du trigger de Schmitt ST par l'intermédiaire d'une résistance R. L'amplificateur opérationnel a donc une fonction d'intégrateur et les tensions aux bornes A et B sont illustrées respectivement en figures 2A et 2B.

Le trigger de Schmitt est un circuit qui fournit une tension à niveau haut quand son entrée a atteint par valeurs croissantes un seuil haut VH et une tension à niveau bas quand son entrée a atteint par valeurs décroissantes un seuil bas VL. Ainsi, la tension à la borne A a l'allure représentée en figure 2A. Pendant une première durée t1, la tension est croissante avec une pente égale à $V_{in}/RC$ et, pendant une deuxième durée t2, elle est décroissante avec une pente $(V_{ref}-V_{in})/RC$, Vref étant la tension d'alimentation du trigger de Schmitt et de l'ensemble du circuit. On a donc sur la sortie B un signal à niveau haut pendant la durée t2 et un niveau bas pendant la durée t1. Si on appelle T la somme des durées t1 et t2, le rapport t2/T est égal à Vin/Vref. Alors, un microcontrôleur connecté à la borne B peut calculer simplement le rapport t2/T, ces valeurs étant mesurées à partir de l'horloge interne du microprocesseur avec une précision supérieure à 10 bits et des calculs étant fait avec une précision supérieure à 10 bits.

Ainsi, le microcontrôleur peut effectuer les calculs avec une précision suffisante mais on s'aperçoit que la précision d'ensemble du système dépend des caractéristiques de l'amplificateur opérationnel INT. En effet, si le but est toujours d'obtenir un système à faible coût, il est connu que les amplificateurs opérationnels à faible coût présentent l'inconvénient de présenter une tension de décalage (tension d'offset) entre leurs entrées. Cette tension d'offset dépend, dans une série donnée, de l'intégrateur particulier et, pour un intégrateur particulier, de sa température et de son vieillissement. Dans l'exemple donné précédemment, où l'on veut calculer avec précision des tensions de l'ordre du volt et du millivolt, la tension d'offset qui sera classiquement de l'ordre de quelques millivolts (q 2 à q 5 mV) est loin d'être négligeable devant la plus basse des tensions à mesurer. En outre, si la tension Vin à mesurer est inférieure à la valeur absolue de la tension d'offset et que cette tension est négative, le système ne pourra plus fonctionner car on ne pourra plus avoir de pente positive pendant l'intervalle t1 décrit en relation avec la figure 2B. Ainsi, les systèmes du type de celui de la figure 1 ne sont applicables qu'à des mesures de tension d'entrée nettement supérieures à la tension d'offset de l'intégrateur utilisé ou bien exigent d'employer des intégrateurs de très haute qualité, c'est-à-dire à très faible tension d'offset.

Un objet de la présente invention est de permettre la réalisation d'un système de conversion analogique/numérique du type décrit en figure 1, dans lequel à la fois l'intégrateur et le microcontrôleur soient des systèmes simples à faible coût.

Pour atteindre cet objet ainsi que d'autres, la présente invention prévoit un système de compensation de l'erreur de décalage d'un amplificateur opérationnel, tel qu'énoncé en revendication 1.

Des modes de réalisation de l'invention sont précisés dans les revendications dépendantes.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :

la figure 1 représente un circuit de convertisseur analogique/numérique selon l'art antérieur ;
les figures 2A et 2B sont des courbes de tension en fonction du temps illustrant le fonctionnement du circuit de la figure 1 ; et
la figure 3 représente un circuit de convertisseur analogique/numérique selon la présente invention.

Le circuit de la figure 3 comprend l'intégrateur INT, la bascule de Schmitt ST, le microcontrôleur, la résistance R et le condensateur C de la figure 1 connectés de la même facon.

De plus, le circuit de la figure 3 prévoit, entre la borne d'entrée de tension à mesurer $V_{in}$ et la borne d'entrée $V^+$ de l'intégrateur, un circuit supplémentaire ayant la double fonction de relever en permanence le niveau de l'entrée $V^+$ de façon qu'il soit toujours positif même en cas d'existence d'une tension de décalage négative et d'assurer une mesure périodique, à des instants choisis, de la tension de décalage de l'amplificateur opérationnel pour permettre de la corriger.

Dans un mode de réalisation de la présente invention, ce circuit supplémentaire comprend entre la borne $V_{in}$ et la borne $V^+$ de l'amplificateur opérationnel des résistances en série R1 et R2. Une résistance R3 est connectée entre la borne d'entrée $V^+$ et une tension de référence $V_{ref}$, par exemple la tension d'alimentation de la bascule de Schmitt ST. Un commutateur SW, de préférence un commutateur statique commandé, est connecté entre le point de connexion des résistances R1 et R2 et la masse.

Le fonctionnement normal du circuit correspond à un état ouvert du commutateur SW. Alors, la tension sur la borne $V^+$ est égale à :

$$V^+ = [R3/(R1+R2+R3)]V_{in} + [(R1+R2)/(R1+R2+R3)]V_{ref} + V_{ofs}$$

où $V_{ofs}$ est la tension de décalage (inconnue) de l'amplificateur opérationnel.

Si R3 est nettement supérieur à R1 et R2, on peut écrire en première approximation :

$$V^+ = V_{in} + [(R1+R2)/R3]V_{ref} + V_{ofs}.$$

Le rapport (R1+R2)/R3 est choisi pour que son produit par la valeur Vref soit supérieur à la valeur maximum possible de la tension de décalage $V_{ofs}$, par exemple 5 millivolts. Ainsi, si $V_{ref}$=5 volts, on choisira (R1+R2)/R3=1/1000. On voit donc que l'approximation proposée de négliger R1 et R2 par rapport à R3 est tout à fait acceptable.

Grâce à cette mesure, la tension sur la borne $V^+$ sera toujours supérieure à la tension sur la borne $V^-$, dès qu'une tension Vin, même très faible, est appliquée. Le fonctionnement du système est donc assuré.

En outre, à la mise en marche du système, et ensuite de façon périodique, par exemple à chaque recharge d'une batterie si le circuit est destiné à vérifier la charge d'une batterie, on procède brièvement à une phase de mesure de la tension de décalage en fermant, de préférence sous la commande du microcontrôleur, le commutateur SW. La tension sur la borne $V^+$ est alors :

$$V^+ = [R2/(R2+R3)]V_{ref} + V_{ofs},$$

soit en première approximation :

$$V^+ = (R2/R3)V_{ref} + V_{ofs}.$$

# EP 0 746 094 B1

L'étape de conversion analogique/numérique est alors effectuée avec le commutateur SW fermé, de la façon illustrée en figures 2A et 2B, et l'on peut mesurer $V^+$. Le terme $[R2/(R2+R3)]V_{ref}$ étant connu, Vofs peut en être déduit et cette valeur peut être mémorisée dans le microcalculateur pour servir ensuite à corriger les mesures de $V_{in}$ effectuées.

Par ailleurs, on a indiqué précédemment des approximations dans lesquelles les valeurs de R1, R2 sont négligées par rapport à la valeur de R3. Bien entendu, le microcontrôleur pourra faire des calculs précis en tenant compte des facteurs de correction appliqués.

Ainsi, grâce à la présente invention, on peut effectuer une conversion analogique/numérique de haute précision avec un microcontrôleur dont le convertisseur analogique/numérique interne présente une précision limitée et avec un amplificateur opérationnel à faible coût susceptible de présenter une tension d'offset inconnue non-négligeable.

Bien que l'invention ait été exposée dans le cas d'une application à un convertisseur analogique/numérique, on notera que le système de polarisation positive de l'entrée non-inverseuse d'un amplificateur opérationnel et de détermination de sa tension de décalage pourra trouver d'autres applications qui apparaîtront à l'homme de l'art en fonction des problèmes qui lui seront posés.


## Revendications

**1.** Système de compensation de l'erreur de décalage d'un amplificateur opérationnel (INT), **caractérisé en ce qu'**il comprend :

des moyens pour ajouter en permanence à l'entrée de mesure de l'amplificateur opérationnel une tension de compensation positive supérieure à la plus grande valeur négative possible de la tension d'erreur de décalage de l'amplificateur opérationnel ;
des moyens pour déterminer la valeur de la somme de la tension de compensation et de la tension d'erreur de décalage ; et
des moyens pour corriger les mesures de la tension d'entrée de l'amplificateur opérationnel en tenant compte de ladite somme.

**2.** Système selon la revendication 1, **caractérisé en ce qu'**il comprend, entre la borne où est disponible la tension à mesurer (vin) et la borne d'entrée non-inverseuse ($V^+$) de l'amplificateur opérationnel, la connexion en série d'une première (R1) et d'une deuxième (R2) résistance, la borne d'entrée non-inverseuse ($V^+$) étant connectée à une première tension de référence (Vref) par l'intermédiaire d'une troisième résistance (R3) et le point de raccordement des première et deuxième résistances étant connecté à la masse par l'intermédiaire d'un commutateur commandé (SW).

**3.** Convertisseur analogique/numérique **caractérisé en ce qu'**il comprend :

- un amplificateur opérationnel associé à un système de compensation d'erreur de décalage selon la revendication 1 ou 2 ;
- un condensateur (C) connecté entre la sortie et l'entrée inverseuse de l'amplificateur opérationnel ;
- une bascule de Schmitt (ST) connectée à la sortie de l'amplificateur opérationnel ;
- une résistance (R) connectée entre la sortie de la bascule de Schmitt et l'entrée inverseuse de l'amplificateur opérationnel ; et un microcontrôleur connecté à la sortie de la bascule de Schmitt.

**4.** Convertisseur selon la revendication 3 prise dans son rattachement à la revendication 2, **caractérisé en ce que** le microcontrôleur est programmé pour calculer la tension de décalage de l'amplificateur opérationnel, quand ledit commutateur est fermé.

**5.** Convertisseur selon la revendication 4, **caractérisé en ce que** le microcontrôleur est programmé pour calculer la tension à mesurer (Vin) par comptage de temps, en effectuant une correction d'erreur de décalage, quand ledit commutateur est ouvert.


## Patentansprüche

**1.** System zur Kompensation des OFFSET-Versetzungsfehlers eines Operationsverstärkers (INT), **dadurch gekennzeichnet, daß** das System umfaßt:

Mittel zur permanenten Zufügung am Meßeingang des Operationsverstärkers einer positiven Kompensationsspannung, die größer als der größtmögliche negative Wert der OFFSET-Fehlerspannung des Operationsverstärkers ist;

Mittel zur Bestimmung des Betrags der Summe der Kompensationsspannung und der OFFSET-Fehlerspannung; sowie

Mittel zur Korrektur der Messungen der Eingangsspannung des Operationsverstärkers unter Berücksichtigung der genannten Summe.

2. System nach Anspruch 1, **dadurch gekennzeichnet, daß** es zwischen dem Anschluß, an welchem die zu messende Spannung (Vin) verfügbar ist, und dem nicht-invertierenden Eingang (V⁺) des Operationsverstärkers die Reihenschaltung eines ersten (R1) und eines zweiten (R2) Widerstands aufweist, wobei der nicht-invertierende Eingangsanschluß (V⁺) mit einer ersten Bezugsspannung (Vref) über einen dritten Widerstand (R3) und der Knotenpunkt zwischen dem ersten und dem zweiten Widerstand über einen steuerbaren Schalter (SW) mit Masse verbunden ist.

3. Analog/Digital-Wandler, **dadurch gekennzeichnet daß** er umfaßt:

- einen einem System zur OFFSET-Fehlerkompensation nach Anspruch 1 oder 2 zugeordneten Operationsverstärker;

- einen Kondensator (C) zwischen dem Ausgang und dem invertierenden Eingang des Operationsverstärkers;

- eine mit dem Ausgang des Operationsverstärkers verbundene Schmitt-Triggerschaltung (ST);

- einen zwischen dem Ausgang der Schmitt-Triggerschaltung und dem invertierenden Eingang des Operationsverstärkers angeschlossenen Widerstand (R); sowie

- einen mit dem Ausgang der Schmitt-Triggerschaltung verbundenen Mikrokontroller.

4. Wandler nach Anspruch 3 in Verbindung mit Anspruch 2, **dadurch gekennzeichnet, daß** der Mikrokontroller zur Berechnung der OFFSET-Spannung des Operators programmiert ist, wenn der Umschalter geschlossen ist.

5. Wandler nach Anspruch 4, **dadurch gekennzeichnet, daß** der Mikrokontroller zur Berechnung der zu messenden Spannung durch Zeitzählung unter Durchführung einer OFFSET-Fehlerkorrektur programmiert ist, wenn der genannte Umschalter geöffnet ist.

**Claims**

1. A system for compensating the offset of an operational amplifier (INT), **characterized in that** it includes:

means for continuously adding to the measurement input of the operational amplifier a positive compensation voltage higher than the highest possible negative value of the offset voltage of the operational amplifier;
means for determining the value of the sum of the compensation voltage and the offset voltage; and
means for correcting the measurements of the input voltage of the operational amplifier by taking into account said sum.

2. A system according to claim 1, **characterized in that** it includes, between the terminal at which the voltage to be measured is available ($V_{in}$) and the non-inverting input terminal of the amplifier (V⁺), the series connection of a first (R1) and a second (R2) resistor, with the non-inverting input terminal (V⁺) being connected to a first reference voltage ($V_{ref}$) through a third resistor (R3) and the junction of the first and second resistors being grounded through a controlled switch (SW).

3. An A/D converter **characterized in that** it includes:

- an operational amplifier associated with an offset compensating system according to claim 1 or 2;

- a capacitor (C) connected between the output and the inverting input of the operational amplifier;
- a Schmitt trigger (ST) connected to the output of the operational amplifier;
- a resistor (R) connected between the output of the Schmitt trigger and the inverting input of the operational amplifier; and
- a microcontroller connected to the output of the Schmitt trigger.

4. A converter according to claims 2 and 3, wherein the microcontroller is programmed to calculate the offset voltage of the operational amplifier, when said switch is closed.

5. A converter according to claim 4, wherein the microcontroller is programmed to calculate the voltage to be measured ($V_{in}$) by time counting, by performing an offset correction, when said switch is open.

EP 0 746 094 B1

Fig 1

Fig 2A

Fig 2B

Fig 3

7